# EUROPEAN PATENT SPECIFICATION

(11) **EP 0 713 970 B1**
(45) Date of publication and mention of the grant of the patent: **13.10.1999**
(21) Application number: 95120721.6
(22) Date of filing: 30.11.1992
(51) Int. Cl.: F02P 17/00, G01R 15/06, G01R 31/00

(54) **A spark plug voltage probe device for an internal combustion engine**
Spannungstester für Zündkerzen in einer Brennkraftmaschine
Testeur de potentiel de bougie d'allumage dans un moteur à combustion interne

(30) Priority: 28.11.1991 JP 31478391; 29.11.1991 JP 31668591; 11.05.1992 JP 11768392; 13.11.1992 JP 30385992
(43) Date of publication of application: 29.05.1996
(62) Divisional of application: 92310909.4
(73) Proprietor: NGK SPARK PLUG CO., LTD, Nagoya-shi (JP)
(72) Inventor: Miyata, Shigeru, Takatsuji-cho, Mizuho-ku, Nagoya-shi (JP); Yoshida, Hideji, Takatsuji-cho, Mizuho-ku, Nagoya-shi (JP); Yamada, Yoshitaka, Takatsuji-cho, Mizuho-ku, Nagoya-shi (JP); Ito, Yasuo, Takatsuji-cho, Mizuho-ku, Nagoya-shi (JP); Matsubara, Yoshihiro, Takatsuji-cho, Mizuho-ku, Nagoya-shi (JP)
(74) Representative: Senior, Alan Murray

(56) References cited:
- EP-A- 0 032 647
- GB-A- 2 116 329
- US-A- 4 090 130
- US-A- 5 001 431

## Description

This invention relates to a probe for the detection of voltages applied to spark plugs to detect faulty firing in an internal combustion engine.

With the demand of purifying emission gas and enhancing fuel efficiency of internal combustion engines, it has been necessary to detect the firing condition in each cylinder of the internal combustion engine so as to protect the internal combustion plug against misfire. In order to detect the firing condition in each of the cylinders it is known to install an optical senor within the cylinders. Alternatively, it is also known to attach a piezoelectrical sensor to a seat pad of each spark plug.

Using the prior art, it is troublesome and time-consuming to install a sensor for each of the cylinders, thus increasing the installation cost, and at the same time, taking up a lot of time to check and in maintenance.

Document GB-A-2,116,329, upon which the preamble of claim 1 is based, describes a system for recognising misfirings on the basis of voltage change signals in a capacitance formed between spark plug cables held in grooves and a correspondingly corrugated electrode.

It is one of the objects of the invention to provide a spark plug voltage probe device for an internal combustion engine which is capable of detecting a voltage applied to the spark plug of each cylinder of the internal combustion engine precisely, with a relatively simple structure.

According to one aspect of the present invention, there is provided a spark plug voltage probe device for attachment to an internal combustion engine and for detecting a voltage applied to spark plugs installed in the internal combustion engine by way of corresponding cables, said device comprising:
an insulator base having a plurality of grooves in which the corresponding cables are to be placed;
an electrode layer having two side portions with a central portion between them and embedded in the insulator base along the grooves to form a static capacitance between the electrode layer and placed cables when the voltage is applied across the spark plugs; and
a lead wire provided for electrically connecting the electrode layer to a microcomputer, so as to analyse the burning condition in the internal combustion engine on the basis of the voltage applied to each of the spark plugs;
characterised in that
the two side portions of the electrode layer are of greater length, in the longitudinal direction of the grooves, than the central portion, to form substantially an H-shaped configuration in plan view, so that said two side portions contribute more static capacitance than said central portion, so as to even the distribution of the static capacitance across the electrode layer.

According to a second aspect of the present invention, there is provided a spark plug voltage probe device for attachment to an internal combustion engine and for detecting a voltage applied to spark plugs installed in the internal combustion engine by way of corresponding cables, said device comprising:
an insulator base having a plurality of grooves in which the correspondence cables are to be placed;
an electrode layer having two side portions with a central portion between them and embedded in the insulator base across and along the grooves to form a static capacitance between the electrode layer and placed cables when the voltage is applied across the spark plugs; and
a lead wire provided for electrically connecting the electrode layer to a microcomputer, so as to analyse the burning condition in the internal combustion engine on the basis of the voltage applied to each of the spark plugs;
characterised in that
the electrode layer comprises a rectangular flat sheet having a central opening, so that said two side portions contribute more static capacitance than said central portion, so as to even the distribution of the static capacitance across the electrode layer.

According to a third aspect of the present invention, there is provided a spark plug voltage probe device for attachment to an internal combustion engine and for detecting a voltage applied to spark plugs installed in the internal combustion engine by way of corresponding cables, said device comprising:
an insulator base having a plurality of grooves in which the corresponding cables are to be placed;
an electrode layer having two side portions with a central portion between them and embedded in the insulator base across and along the grooves to form a static capacitance between the electrode layer and placed cables when the voltage is applied across the spark plugs; and
a lead wire provided for electrically connecting the electrode layer to a microcomputer, so as to analyse the burning condition in the internal combustion engine on the basis of the voltage applied to each of the spark plugs;
characterised in that
the electrode layer comprises a rectangular sheet, the central portion of the electrode layer being flat and said side portions being upturned towards the grooves to be closer to cables placed in said grooves that the central portion is, so that said two side portions contribute more static capacitance than said central portion, so as to even the distribution of the static capacitance across the electrode layer.

According to the invention, a substantially uniform static capacitance is formed between the insulator base and spark plug cables which is sufficient to detect a spark plug voltage in each of the cylinders in the combustion engine using the single spark plug voltage probe device.

A substantially uniform static capacitance is formed between each spark plug cable and corresponding groove of a grooved electrode layer, so that a substantially constant level of spark plug voltage is obtained in each cylinder of the internal combustion engine, thus making it possible to detect a burning condition in the internal combustion engine precisely.

Advantageously, with the use of an electrical shield sheet, it is possible to prevent a static capacitance from occurring between the electrode layer and the periphery of the engine when the device is mounted on an engine, thus avoiding sensitivity variation of the spark plug voltage probe device depending on where the probe device is mounted on the engine.

The invention will be further understood from the following description, meant by way of example only, with reference to the accompanying drawings, in which:
Fig. 1 is a perspective exploded view of a spark plug voltage probe device useful in explaining the present invention;
Fig. 2 is a perspective view of the spark plug voltage probe device of Fig. 1;
Fig. 3 is a perspective view with the spark plug voltage probe device of Fig. 1 mounted on an internal combustion engine;
Fig. 4 is a schematic view of an ignition system incorporated into an internal combustion engine;
Fig. 5 is a view similar to Fig. 1 according to a second non-embodiment of the invention;
Fig. 6 is a view similar to Fig. 1 according to a third non-embodiment of the invention;
Fig. 7 is view similar to Fig. 1 according to a first embodiment of the invention;
Fig. 8 is a view similar to Fig. 3 according to the first embodiment of the invention;
Fig. 9 is a view similar to Fig. 1 according to a second embodiment of the invention;
Fig. 10 is a longitudinal cross sectional view of a spark plug voltage probe device according to a third embodiment of the invention;
Fig. 11 is a view similar to Fig. 10 according to a fourth embodiment of the invention.

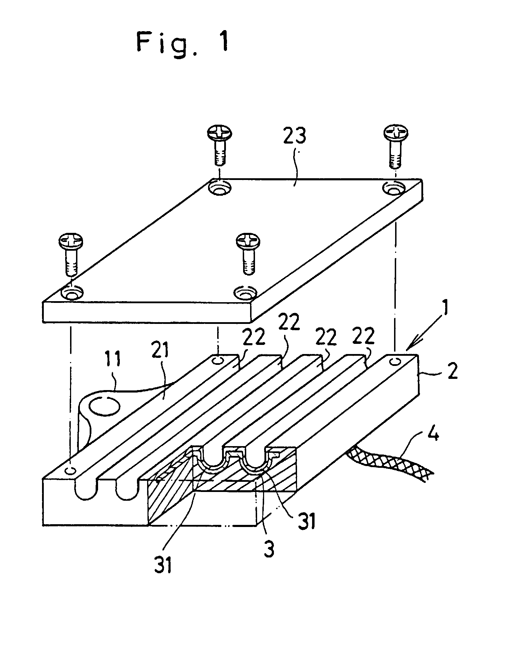

Referring to Fig. 1, this shows a spark plug voltage probe device 1 in an internal combustion engine. This is not in accordance with the present invention but is useful for understanding it. An insulator base 2 has a rectangular upper surface 21 in which a plurality of grooves 22 are provided at regular intervals in a longitudinal direction. Each of the grooves 22 is U-shaped in section. Each diameter of the grooves 22 corresponds to that of spark plug cables (HC), and the number of the grooves 22 corresponds to that of cylinders of the internal combustion engine. Along the grooves 22, an electrode plate 3 is embedded in the insulator base 2. The electrode plate 3 is in the form of a corrugated configuration which has channels 31 corresponding to the grooves 22 of the insulator base 2. The electrode plate 3 is embedded in the insulator base 2 at the time when the insulator base 2 is formed by means of an injection mould, and electrode plate 3 is electrically connected to a microcomputer as described hereinafter. An anchor block 11 is moulded at a side wall of the insulator base 2.

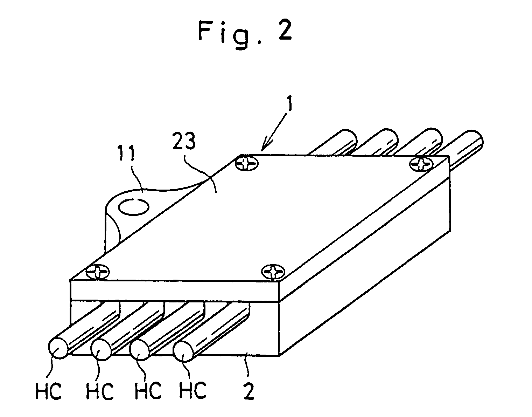

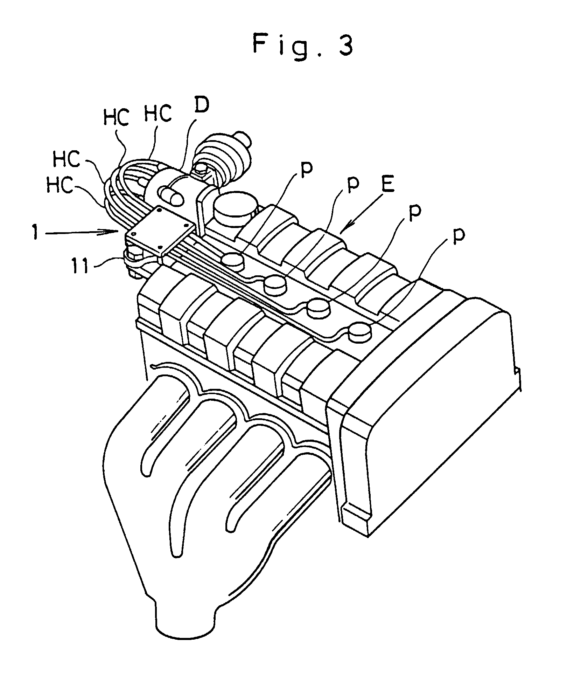

In each of the grooves 22, a cable (HC) is located to form a static capacitance (e.g. 1 pF) between the electrode plate 3 and the cables (HC) as shown in Figure 2. On the upper surface 21 of the insulator base 2, a lid 23 is placed to secure each of the cables (HC) against removal. Then the spark plug voltage probe device 1 is mounted on an internal combustion engine (E) by securing the anchor block 11 to a cylinder head of the internal combustion engine (E), and collects the cables (HC) to introduce them to a distributor (D) as shown in Fig. 3.

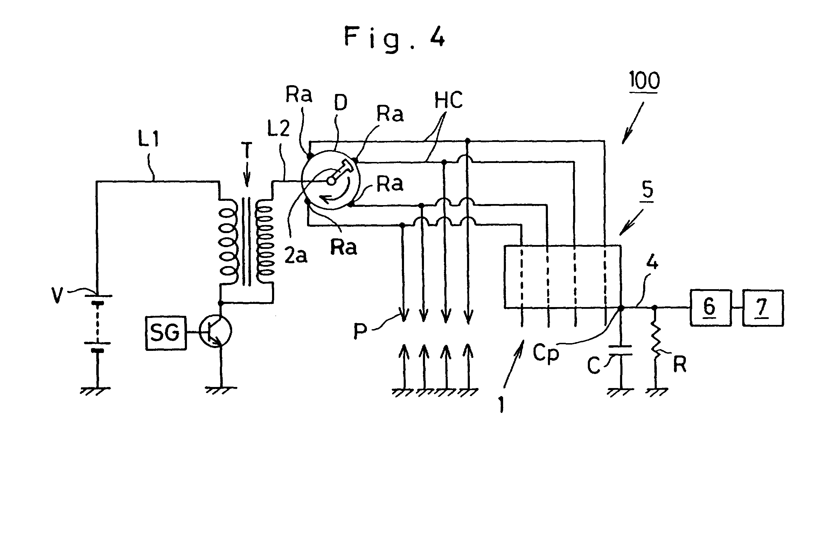

Fig. 4 shows an ignition system 100 which is incorporated into the internal combustion engine (E). The ignition system has an ignition coil (T) having a primary coil (L1) and a secondary coil (L2). In series with the primary coil (L1), a vehicular battery cell (V) and a signal generator (SG) are connected. Each of the cables (HC) has one end electrically connected to the secondary coil (L2) through a rotor 2a of the distributor (D) which integrally incorporates a contact breaker (not shown) and has e.g. four stationary segments (Ra). To each of the stationary segments (Ra), a free end of the rotor 2a approaches to make a series gap with the corresponding segments (Ra) during the rotary movement of the rotor 2a. To each of the four stationary segments (Ra), a spark plug (P) is electrically connected by way of the corresponding cables (HC). Each of the spark plugs (P) is electrically connected to ground so that the secondary coil (L2) energizes each of the spark plugs (P) by way of the cables (HC), the rotor 2a and the stationary segment (Ra) of the distributor (D).

A common point (Cp) between the electrode plate 3 and a lead wire 4, is grounded by way of a capacitor C (3000 pF) to form a voltage divider circuit 5. In parallel with the capacitor (C), an electrical resistor R (e.g. 3 MΩ) is connected to form a discharge circuit for the capacitor (C). The voltage divider circuit 5 divides a spark plug voltage by the order of 3000. The RC time constant is 9 milliseconds, thus making it possible to observe a relatively slow change in the spark plug voltage.

Meanwhile, the lead wire 4 is connected to a spark plug voltage waveform detector circuit 6. The circuit 6 is connected to a distinction circuit (microcomputer) 7 which analyses a burning condition in the internal combustion engine (E) on the basis of the waveform outputted from the circuit 6 as described hereinafter.

The spark plug voltage waveform detector circuit 6 analyses a divided voltage waveform generated from the voltage divider circuit 5, and compares the characteristics of the divided voltage waveform with data determined by experiment.

The divided voltage waveform is analogous to that of the spark plug voltage, and changes depending upon the case in which an air-fuel mixture is normally ignited, and the case in which the air-fuel mixture is not ignited although a spark is established by the spark plug (P). The divided voltage waveform also changes depending upon the smoking of the spark plug (P), deterioration of the ignition coil (T) and a shortage of the vehicular battery cell (V).

Analysis of the divided voltage waveform makes it possible to distinguish normal ignition from accidental misfire and misspark.

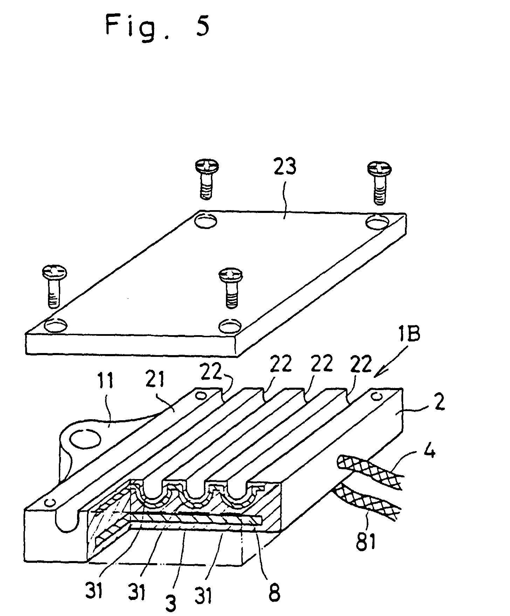

Fig. 5 shows a second non-embodiment of the invention in which a spark plug voltage probe device 1B has an electrical shield sheet 8 embedded in the insulator base 2 of the first non-embodiment, located under the electrode plate 3. The electrical shield sheet 8 is connected to the internal combustion engine (E) by way of a ground wire 81.

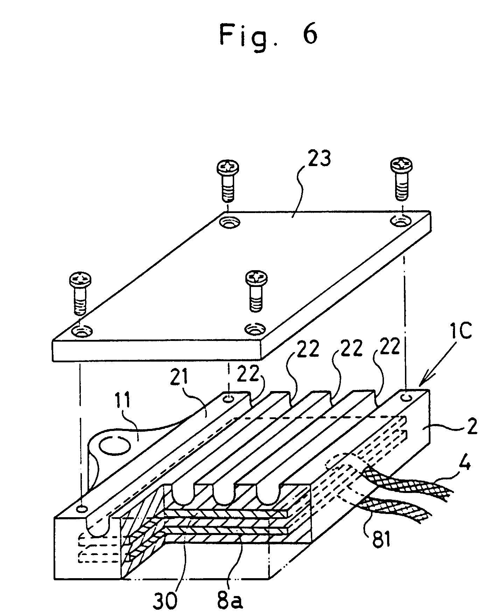

Fig. 6 shows a third non-embodiment of the invention in which a spark plug voltage probe device 1C has an electrical shield sheet 8a embedded in the insulator base 2, located under the electrode plate 30. The electrical shield sheet 8 is connected to the internal combustion engine (E) by way of the ground wire 81. It is observed that the electrical shield sheet may be in the form of meshes or a layer.

With the use of the electrical shield sheet, it is possible to prevent capacitive variation between the electrode plate and the cables when some metallic conductor is present at the periphery of the spark plug voltage probe device. This enables precise detection of the voltage waveform from the voltage divider circuit.

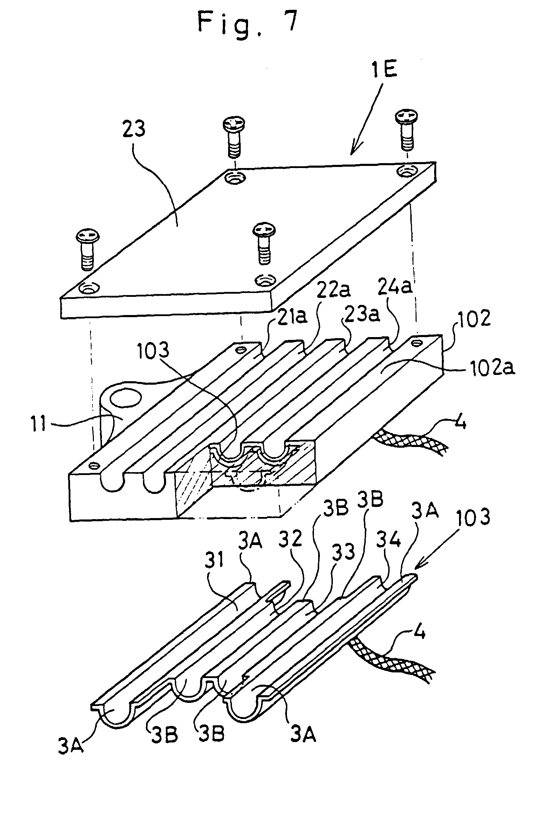

Fig. 7 shows a first embodiment of the invention, in which a spark plug voltage probe device 1E has a rectangular insulator base 102, upper surface 102a of which has grooves 21a ∼ 24a at regular intervals in a longitudinal direction. Along the grooves 21a ∼ 24a, an electrode plate 103 is embedded in the insulator base 102 to form a static capacitance between the electrode plate 103 and spark plug cables 41 ∼ 44 which are liquid-tightly placed in the corresponding grooves 21a ∼ 24a by way of an adhesive. The electrode plate 103 is in the form of corrugated configuration which has channels 31 ∼ 34 corresponding to the grooves 21a ∼ 24a of insulator base 102.

Among the channels 31 ∼ 34, longitudinal ends 3A, 3A of the outside channels 31, 34 extend beyond longitudinal ends 3B, 3B of the inside channels 32, 33 respectively. Thereby, each length of outside channels 31, 34 is greater than that of the inside channels 32, 33 so as to form substantially an H-shaped configuration as a whole.

This enables the device to compensate effectively for a capacitive shortage so that he static capacitance between the cables 41, 44 and the outside channels 31, 34 is substantially equal to the static capacitance between the cables 42, 43 and the inside channels 32, 33 thus making it possible to avoid differences among the static capacitances between each of the cables and the corresponding channels.

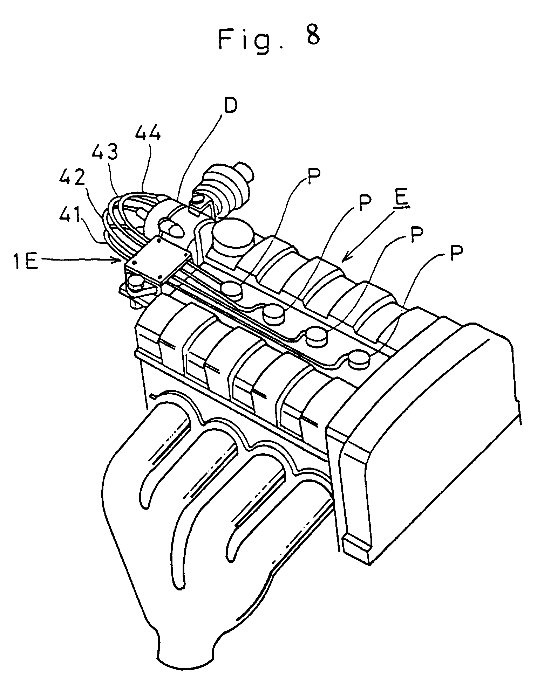

Then the lid 23 is fixed to the upper surface 102a of the insulator base 102 to secure the cables 41 ∼ 44 against removal. The spark plug voltage probe device 1E is mounted on a cylinder head of the internal combustion engine (E), and introducing the cables 41 ∼ 44 to the spark plugs (P) as shown in Fig. 8.

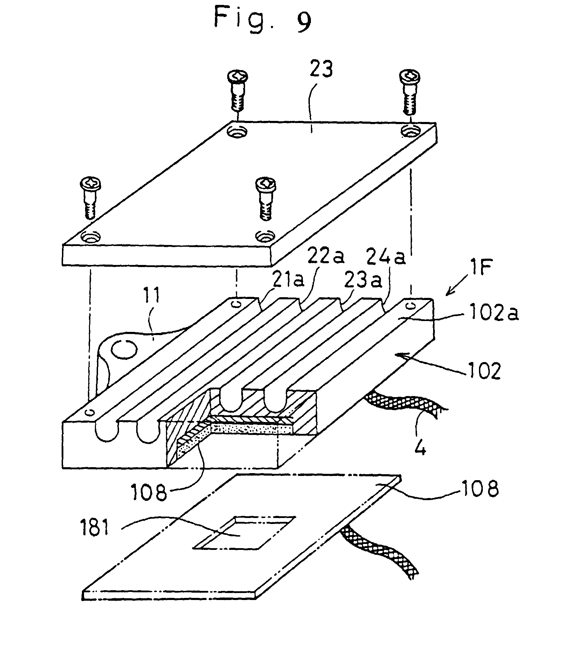

Fig. 9 shows a second embodiment of the invention, in which a spark plug voltage probe device 1F has a rectangular flat sheet 108 as an electrode plate. The flat sheet 108 has a central opening 181 as a capacitance adjusting means which works to decrease the static capacitance between the cables 42, 43 and the flat sheet 108 so as to achieve a substantially uniform distribution between the cables 41 ∼ 44 and the flat sheet 108.

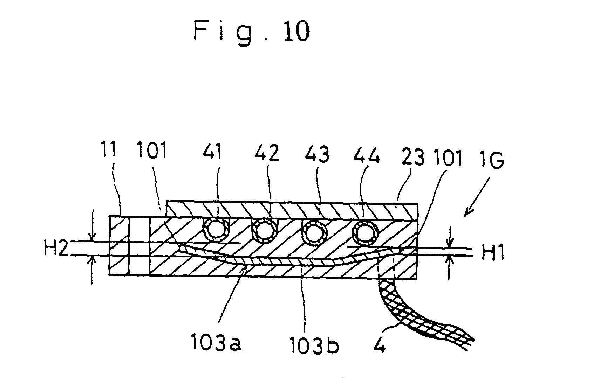

Fig. 10 shows an third embodiment of the invention, in which a spark plug voltage probe device 1G has a rectangular sheet 103a, both sides 101 of which turn upward to approach the cables 41, 44 so that a distance (H1) between the cables 41, 44 and the sides 101 is shorter than a distance (H2) between the cables 42, 43 and a central flat portion 103b of the sheet 103a.

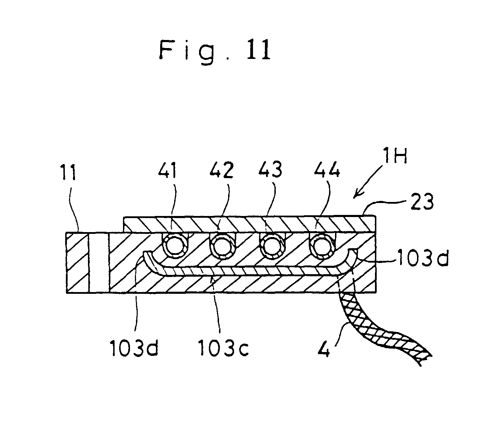

Fig. 11 shows a fourth embodiment of the invention, in which a spark plug voltage probe device 1H has a rectangular flat sheet 103c, both sides 103d of which curl around the cables 41, 44 to form an arcuate configuration.

## Claims

1. A spark plug voltage probe device (1E; 1F; 1G; 1H) for attachment to an internal combustion engine (E) and for detecting a voltage applied to spark plugs (P) installed in the internal combustion engine by way of corresponding cables (41-44), said device comprising:
an insulator base (102) having a plurality of grooves (21a-24a) in which the corresponding cables are to be placed;
an electrode layer (103; 103a; 103c; 108) having two side portions (101; 103d) with a central portion (103b) between them and embedded in the insulator base across and along the grooves to form a static capacitance between the electrode layer and placed cables when the voltage is applied across the spark plugs; and
a lead wire (4) provided for electrically connecting the electrode layer to a microcomputer, so as to analyse the burning condition in the internal combustion engine on the basis of the voltage applied to each of the spark plugs; characterised in that
the two side portions (3A) of the electrode layer (103) are of greater length, in the longitudinal direction of the grooves (21a-24a), than the central portion (3B), to form substantially an H-shaped configuration in plan view, so that said two side portions contribute more static capacitance than said central portion, so as to even the distribution of the static capacitance across the electrode layer.

2. A device as recited in claim 1, wherein the electrode layer (103) is corrugated in section, the corrugations corresponding to the grooves (21a-24a).

3. A device as recited in claim 1 or 2, further comprising an electrical shield layer embedded in the insulator base in the proximity of the electrode layer remote from the grooves, so as to shield the electrode layer electrically.

4. A spark plug voltage probe device (1E; 1F; 1G; 1H) for attachment to an internal combustion engine (E) and for detecting a voltage applied to spark plugs (P) installed in the internal combustion engine by way of corresponding cables (41-44), said device comprising:
an insulator base (102) having a plurality of grooves (21a-24a) in which the corresponding cables are to be placed;
an electrode layer (103; 103a; 103c; 108) having two side portions (101; 103d) with a central portion (103b) between them and embedded in the insulator base across and along the grooves to form a static capacitance between the electrode layer and placed cables when the voltage is applied across the spark plugs; and
a lead wire (4) provided for electrically connecting the electrode layer to a microcomputer, so as to analyse the burning condition in the internal combustion engine on the basis of the voltage applied to each of the spark plugs; characterised in that
the electrode layer (108) comprises a rectangular flat sheet having a central opening (181), so that said two side portions contribute more static capacitance than said central portion, so as to even the distribution of the static capacitance across the electrode layer.

5. A device as recited in claim 4, wherein the central opening (181) is rectangular.

6. A spark plug voltage probe device (1E; 1F; 1G; 1H) for attachment to an internal combustion engine (E) and for detecting a voltage applied to spark plugs (P) installed in the internal combustion engine by way of corresponding cables (41-44), said device comprising:
an insulator base (102) having a plurality of grooves (21a-24a) in which the corresponding cables are to be placed;
an electrode layer (103; 103a; 103c; 108) having two side portions (101; 103d) with a central portion (103b) between them and embedded in the insulator base across and along the grooves to form a static capacitance between the electrode layer and placed cables when the voltage is applied across the spark plugs; and
a lead wire (4) provided for electrically connecting the electrode layer to a microcomputer, so as to analyse the burning condition in the internal combustion engine on the basis of the voltage applied to each of the spark plugs; characterised in that
the electrode layer comprises a rectangular sheet, the central portion (103b) of the electrode layer (103a; 103c) being flat and said side portions (101; 103d) being upturned towards the grooves (21a-24a) to be closer to cables (41-44) placed in said grooves than the central portion is, so that said two side portions contribute more static capacitance than said central portion, so as to even the distribution of the static capacitance across the electrode layer.

7. A device (1G) as recited in claim 6, wherein the side portions (101) are flat.

8. A device (1H) as recited in claim 6, wherein the side portions (103d) curl around the cables to form an arcuate configuration.

9. A device (1E;1F;1G;1H) as recited in any one of the preceding claims wherein said cables (41-44) are liquid-tightly held in said grooves (21a-24a) by way of an adhesive.

## Patentansprüche

1. Zündkerzenspannungsmessfühler (1E; 1F; 1G; 1H) zur Anbringung an einem Verbrennungsmotor (E) mit innerer Verbrennung und zur Erfassung einer Zündkerzen (P), die in den Verbrennungsmotor eingesetzt sind durch entsprechende Kabel (41-44) zugeführten Spannung, wobei der Zündkerzenspannungsmessfühler aufweist:
einen Isoliersockel (102), der mehrere Rillen (21a-24a) hat, in die die entsprechenden Kabel zu liegen kommen;
eine Elektrodenlage (103; 103a; 103c; 108), die zwei Seitenabschnitte (101; 103d) mit einem zwischen ihnen liegenden Mittelabschnitt (103b) hat und die in den Isoliersockel über und entlang den Rillen eingebettet ist, so dass eine statische Kapazität zwischen der Elektrodenlage und den eingelegten Kabeln gebildet wird, wenn Spannung den Zündkerzen anliegt, und
einen Leitungsdraht (4) zur elektrischen Verbindung der Elektrodenlage mit einem Mikrocomputer, um so eine Verbrennungssituation im Verbrennungsmotor auf der Basis der jeder Zündkerze angelegten Spannung zu analysieren;
dadurch gekennzeichnet, dass
die beiden Seitenabschnitte (3A) der Elektrodenlage (103) in Längsrichtung der Rillen (21a-24a) länger sind als der Mittelabschnitt (3B) der Elektrodenlage (103), so dass diese in ebener Ansicht eine H-förmige Gestalt hat und die beiden Seitenabschnitte mehr zur statischen Kapazität beitragen als der Mittelabschnitt, um die statische Kapazität über der Elektrodenlage gleichförmig zu verteilen.

2. Zündkerzenspannungsmessfühler nach Anspruch 1, bei dem die Elektrodenlage (103) abschnittsweise gewellt ist und die Wellen den Rillen (21a-24a) entsprechen.

3. Zündkerzenspannungsmessfühler nach Anspruch 1 oder 2, der weiterhin eine elektrische Abschirmlage aufweist, die in den Isoliersockel in der Nähe der Elektrodenlage im Abstand von den Rillen eingebettet ist und so die Elektrodenlage elektrisch abschirmt.

4. Zündkerzenspannungsmessfühler (1E; 1F; 1G; 1H) zur Anbringung an einem Verbrennungsmotor (E) mit innerer Verbrennung und zur Erfassung einer Zündkerzen (P), die in den Verbrennungsmotor eingesetzt sind, durch entsprechende Kabel (41-44) zugeführten Spannung, wobei der Zündkerzenspannungsmessfühler aufweist:
einen Isoliersockel (102), der mehrere Rillen (21a-24a) hat, in die die entsprechenden Kabel zu liegen kommen;
eine Elektrodenlage (103; 103a; 103c; 108), die zwei Seitenabschnitte (101; 103d) mit einem zwischen ihnen liegenden Mittelabschnitt (103b) hat und die in den Isoliersockel über und entlang den Rillen eingebettet ist, so dass eine statische Kapazität zwischen der Elektrodenlage und den eingelegten Kabeln gebildet ist, wenn Spannung den Zündkerzen anliegt; und
einen Leitungsdraht (4) zur elektrischen Verbindung der Elektrodenlage mit einem Mikrocomputer, um so eine Verbrennungssituation im Verbrennungsmotor auf der Basis der jeder Zündkerze angelegten Spannung zu analysieren;
dadurch gekennzeichnet, dass
die Elektrodenlage (108) ein rechtwinkliges flaches Blatt mit einer zentralen Öffnung (181) so aufweist, dass die beiden Seitenabschnitte zur statischen Kapazität mehr beitragen als der Mittelabschnitt, um so die Verteilung der statischen Kapazität über der Elektrodenlage auszugleichen.

5. Zündkerzenspannungsmessfühler nach Anspruch 4, bei dem die zentrale Öffnung (181) rechtwinklig ist.

6. Zündkerzenspannungsmessfühler (1E; 1F; 1G; 1H) zur Anbringung an einem Verbrennungsmotor (E) mit innerer Verbrennung und zur Erfassung einer Zündkerzen (P), die in den Verbrennungsmotor eingesetzt sind durch entsprechende Kabel (41-44) zugeführten Spannung, wobei der Zündkerzenspannungsmessfühler aufweist:
einen Isoliersockel (102), der mehrere Rillen (21a-24a) hat, in die die entsprechenden Kabel zu liegen kommen;
eine Elektrodenlage (103; 103a, 103c; 108), die zwei Seitenabschnitte (101; 103d) mit einem zwischen ihnen liegenden Mittelabschnitt (103e) hat und die in den Isoliersockel über und entlang den Rillen eingebettet ist, so dass eine statische Kapazität zwischen der Elektrodenlage und den eingelegten Kabeln gebildet ist, wenn Spannung den Zündkerzen anliegt, und
einen Leitungsdraht (4) zur elektrischen Verbindung der Elektrodenlage mit einem Mikrocomputer, um so eine Verbrennungssituation im Verbrennungsmotor auf der Basis der jeder Zündkerze angelegten Spannung zu analysieren;
dadurch gekennzeichnet, dass
die Elektrodenlage ein rechtwinkliges Blatt aufweist, der Mittelabschnitt (103b) der Elektrodenlage (103a; 103c) flach ist und die Seitenabschnitte (101; 103d) zu den Rillen (21a-24a) hochgebogen sind und so näher an den in die Rillen gelegten Kabeln (41-44) liegen als der Mittelabschnitt, so dass die beiden Seitenabschnitte mehr zur statischen Kapazität als der Mittelabschnitt beitragen und dadurch die Verteilung der statischen Kapazität über der Elektrodenlage ausgleichen.

7. Zündkerzenspannungsmessfühler (1G) nach Anspruch 6, bei dem die beiden Seitenabschnitte (101) flach sind.

8. Zündkerzenspannungsmessfühler (1H) nach Anspruch 6, bei dem die Seitenabschnitte (103d) um die Kabel herum abgerundet sind und eine bogenförmige Gestalt haben.

9. Zündkerzenspannungsmessfühler (1E; 1F; 1G; 1H) nach einem der vorangehenden Ansprüche, bei dem die Kabel (41-44) mittels eines Klebstoffs flüssigkeitsdicht in den Rillen (21a-24a) gehalten sind.

## Revendications

1. Dispositif testeur de potentiel de bougie d'allumage (1E ; 1F ; 1G ; 1H) destiné à être fixé dans un moteur à combustion interne (E) et à détecter une tension appliquée à des bougies d'allumage (P) installées dans le moteur à combustion interne au moyen de câbles correspondants (41-44), ledit dispositif comprenant :
une base isolante (102) possédant une pluralité de gorges (21a-24a) dans lesquelles les câbles correspondants doivent être placés ;
une couche d'électrode (103 ; 103a ; 103c ; 108) comportant deux portions latérales (101 ; 103d) avec une portion centrale (103b) entre elles et noyée dans la base isolante en travers et le long des gorges pour former une capacité statique entre la couche d'électrode et les câbles mis en place lorsque la tension est appliquée aux bougies d'allumage ; et
un fil conducteur (4) prévu pour connecter électriquement la couche d'électrode à un micro-ordinateur de façon à analyser la condition de combustion dans le moteur à combustion interne sur la base de la tension appliquée à chacune des bougies d'allumage; caractérisé en ce que
les deux portions latérales (3A) de la couche d'électrode (103) sont de plus grande longueur, dans la direction longitudinale des gorges (21a-24a), que la portion centrale (3B), pour former sensiblement une configuration en forme de H en vue en plan, de telle sorte que les deux portions latérales contribuent plus à la capacité statique que ladite portion centrale, de manière à rendre régulière la distribution de la capacité statique à travers la couche d'électrode.

2. Dispositif selon la revendication 1, dans lequel la couche d'électrode (103) est cannelée en section, les cannelures correspondant aux gorges (21a-24a).

3. Dispositif selon la revendication 1 ou 2, comprenant en outre une couche de blindage électrique noyée dans la base isolante à proximité de la couche d'électrode à l'écart des gorges, de façon à réaliser un blindage électrique de la couche d'électrode.

4. Dispositif testeur de potentiel de bougie d'allumage (1E ; 1F ; 1G ; 1H) destiné à être fixé dans un moteur à combustion interne (E) et à détecter une tension appliquée à des bougies d'allumage (P) installées dans le moteur à combustion interne au moyen de câbles correspondants (41-44), ledit dispositif comprenant :
une base isolante (102) possédant une pluralité de gorges (21a-24a) dans lesquelles les câbles correspondants doivent être placés ;
une couche d'électrode (103 ; 103a ; 103c ; 108) comportant deux portions latérales (101 ; 103d) avec une portion centrale (103b) entre elles et noyée dans la base isolante en travers et le long des gorges pour former une capacité statique entre la couche d'électrode et les câbles mis en place lorsque la tension est appliquée aux bougies d'allumage; et
un fil conducteur (4) prévu pour connecter électriquement la couche d'électrode à un micro-ordinateur de façon à analyser la condition de combustion dans le moteur à combustion interne sur la base de la tension appliquée à chacune des bougies d'allumage; caractérisé en ce que
la couche d'électrode (108) comprend une feuille plane rectangulaire possédant une ouverture centrale (181), de telle sorte que lesdites deux portions latérales contribuent plus à la capacité statique que ladite portion centrale de façon à rendre régulière la distribution de la capacité statique à travers la couche d'électrode.

5. Dispositif selon la revendication 4 dans lequel l'ouverture centrale (181) est rectangulaire.

6. Dispositif testeur de potentiel de bougie d'allumage (1E ; 1F ; 1G ; 1H) destiné à être fixé dans un moteur à combustion interne (E) et à détecter une tension appliquée à des bougies d'allumage (P) installées dans le moteur à combustion interne au moyen de câbles correspondants (41-44), ledit dispositif comprenant :
une base isolante (102) possédant une pluralité de gorges (21a-24a) dans lesquelles les câbles correspondants doivent être placés ;
une couche d'électrode (103 ; 103a ; 103c ; 108) comportant deux portions latérales (101 ; 103d) avec une portion centrale (103b) entre elles et noyée dans la base isolante en travers et le long des gorges pour former une capacité statique entre la couche d'électrodes et les câbles mis en place lorsque la tension est appliquée aux bougies d'allumage ; et
un fil conducteur (4) prévu pour connecter électriquement la couche d'électrode à un micro-ordinateur de façon à analyser la condition de combustion dans le moteur à combustion interne sur la base de la tension appliquée à chacune des bougies d'allumage; caractérisé en ce que
la couche d'électrode comprend une feuille rectangulaire, la portion centrale (103b) de la couche d'électrode (103a ; 103c) étant plane et lesdites portions latérales (101 ; 103d) étant tournées vers le haut en direction des gorges (21a-24a) de manière à être plus proche des câbles (41-44) placés dans lesdites gorges que ne l'est la portion centrale, de telle sorte que lesdites deux portions latérales contribuent plus à la capacité statique que ladite portion centrale de façon à rendre régulière la distribution de la capacité statique à travers la couche d'électrode.

7. Dispositif (1G) selon la revendication 6, dans lequel les portions latérales (101) sont planes.

8. Dispositif (1H) selon la revendication 6, dans lequel les portions latérales (103d) s'enroulent autour des câbles pour former une configuration en arc.

9. Dispositif (1E; 1F ; 1G ; 1H) selon l'une quelconque des revendications précédentes, dans lequel lesdits câbles (41-44) sont maintenus de manière étanche aux liquides dans lesdites gorges (21a-24a) au moyen d'un adhésif.
